# EUROPEAN PATENT APPLICATION

(11) **EP 4 617 776 A1**
(43) Date of publication of application: **17.09.2025**
(21) Application number: 25156810.1
(22) Date of filing: 10.02.2025
(51) Int. Cl.: G03F 7/12, G03F 7/20

(54) **SYSTEM AND METHOD FOR SILK SCREEN STENCIL FABRICATION USING A LIQUID CRYSTAL DISPLAY PANEL FOR IMAGE TRANSFER**

(30) Priority: 19.02.2024 US 202418581134
(71) Applicant: Geospace Technologies Corporation, Houston, TX 77040 (US)
(72) Inventor: DE LA GUERRA, Gabriel Camiro, Texas, 77040 (US); CASTRO, Raul, Texas, 77040 (US); LAD, Rohan, Texas, 77040 (US); MU, Yuqiang, Texas, 77040 (US)
(74) Representative: Gill Jennings & Every LLP

(57) **Abstract**

A system includes a frame, an ultraviolet light source, an LCD panel, and a computer. The frame is configured to retain a substrate. The LCD panel is positioned between the frame and the ultraviolet light source. The computer is coupled to the LCD panel. The computer is configured to transfer image data to the LCD panel. The image data defines an image to be transferred to the substrate.

## Description

### BACKGROUND

In the silk screen printing process, a material to be printed is placed beneath a silk screen stencil, ink is placed on the silk screen stencil, and the ink is pressed through porous areas of the silk screen stencil by a squeegee or equivalent apparatus. The ink may have a viscosity that inhibits flow of the ink through the porous areas of the silk screen stencil absent application of pressure via the squeegee. After the printing operation has been performed, the printed material is removed from the underside of the silk screen stencil and unprinted material is placed beneath the silk screen stencil for printing as described above.

### SUMMARY

In one example, an apparatus includes a frame, an ultraviolet light source, and a liquid crystal display (LCD) panel. The frame is configured to retain a substrate. The liquid crystal display (LCD) panel is positioned between the frame and the ultraviolet light source.

The frame may be configured to retain a substrate to be printed or to be converted into a silk screen stencil.

The LCD panel may be a transmissive LCD panel.

The ultraviolet light source may include a two-dimensional array of ultraviolet light emitting diodes.

A spherical array lens may be positioned between the ultraviolet light source and the LCD panel.

A cooling system may be disposed on a side of the ultraviolet light source opposite the LCD panel. The cooling system may include one or more fans configured to provide air flow to the ultraviolet light source.

A computer may be coupled to the LCD panel, the computer configured to control the LCD panel to pass ultraviolet light from the ultraviolet light source to the frame in a predetermined pattern.

In another example, a method includes providing a substrate coated with an ultraviolet sensitive emulsion, and providing an image on an LCD panel. The method also includes activating an ultraviolet light source to generate ultraviolet light, and illuminating the substrate by passing the ultraviolet light through the LCD panel to the substrate.

The LCD panel may be a transmissive LCD panel.

Activating the ultraviolet light source may include forward biasing a plurality of light emitting diodes configured to emit ultraviolet light.

The method may further comprise passing the ultraviolet light to the LCD panel through a spherical array lens.

The method may further comprise coupling a computer to the LCD panel; and transmitting image data from the computer to the LCD panel to form the image on the LCD panel.

The method may further comprise mounting the substrate on a frame coupled to the LCD panel.

The method may further comprise removing ultraviolet sensitive emulsion not exposed to the ultraviolet light from the substrate to produce a silk screen stencil.

In a further example, a system includes a frame, an ultraviolet light source, an LCD panel, and a computer. The frame is configured to retain a substrate. The LCD panel is positioned between the frame and the ultraviolet light source. The computer is coupled to the LCD panel. The computer is configured to transfer image data to the LCD panel. The image data defines an image to be transferred to the substrate.

The frame may be configured to retain a substrate to be printed or to be converted into a silk screen stencil.

The image data may configure the LCD panel to pass ultraviolet light representative of the image onto a substrate retained in the frame.

### BRIEF DESCRIPTION OF THE DRAWINGS

For a detailed description of exemplary embodiments, reference will now be made to the accompanying drawings, in which:
FIG. 1 is a front view of an example apparatus for fabricating a stencil for use in silk screen printing.
FIG. 2 is a side view of the example apparatus for fabricating a stencil for use in silk screen printing of FIG. 1.
FIG. 3 is a sectional view of the example apparatus for fabricating a stencil for use in silk screen printing of FIG. 1.
FIG. 4 is a top view of the example apparatus for fabricating a stencil for use in silk screen printing of FIG. 1.
FIG. 5 is an auxiliary view of the example apparatus for fabricating a stencil for use in silk screen printing of FIG. 1.
FIG. 6 is a flow diagram of an example method for fabricating a stencil for use in silk screen printing using the apparatus of FIG. 1.
FIG. 7 is a block diagram of an example system for fabricating a stencil for use in silk screen printing.

### DETAILED DESCRIPTION

In screen printing, ink is transferred to a substrate (e.g., paper, wood, metal, plastic, fabric, etc.) through the mesh of silk screen stencil. The silk screen stencil includes areas in which the mesh is blocked to prevent the passage of ink, and areas in which the mesh is open to allow the passage of ink, thereby defining the image to be printed on the substrate.

A silk screen stencil may be fabricated by coating a fabric mesh (a silk screen) with an ultraviolet sensitive emulsion, and exposing the coated silk screen to ultraviolet light through a physical pattern (e.g., a mylar, acetate, or paper sheet) that defines an image to be printed. After exposure to ultraviolet light, the unexposed emulsion is removed from the silk screen to define the image on the silk screen stencil.

The silk screen stencil fabrication apparatus described herein can reduce the time and cost associated with producing a silk screen stencil by eliminating the need for a physical pattern. In lieu of a physical pattern, the silk screen stencil fabrication apparatus described herein includes a transmissive liquid crystal display (LCD) panel. The LCD panel can be programmed to provide an image that passes (or blocks) ultraviolet light emitted by an ultraviolet light source to a silk screen coated with an ultraviolet sensitive emulsion. The LCD panel can be reprogrammed as needed to provide an image for fabrication of a silk screen stencil.

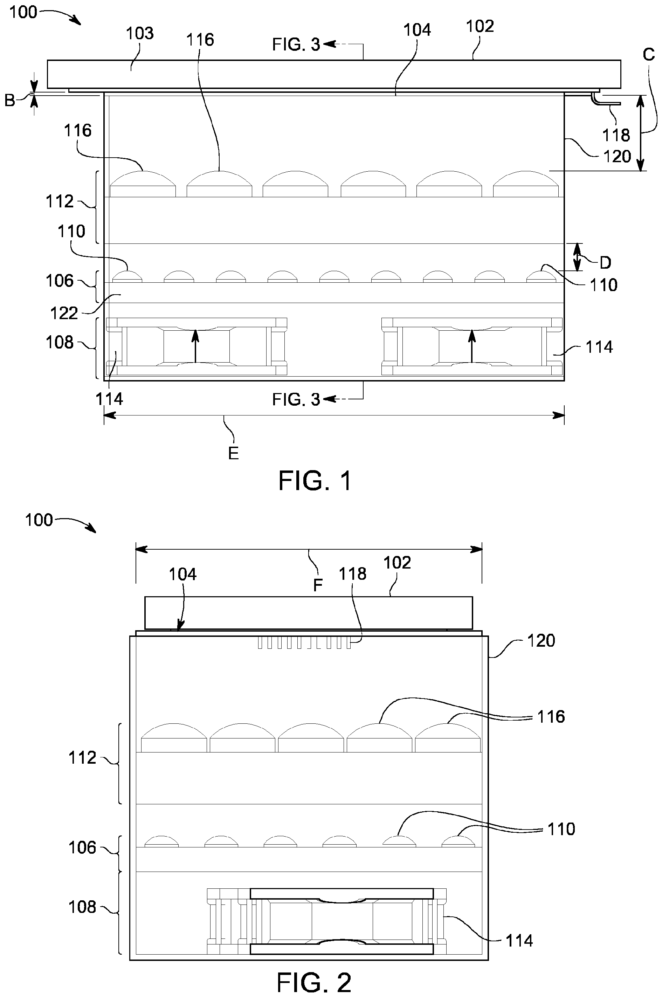

FIG. 1 is a front view of an example apparatus 100 for fabricating a stencil for use in silk screen printing. The apparatus 100 include a silk screen frame 102, an LCD panel 104, and an ultraviolet light source 106. The silk screen frame 102 may be rectangular or square in shape, and includes a rim 103. The rim 103 can retain a sheet of a silk screen material to be transformed into a stencil. The silk screen material may be attached to the silk screen frame 102 using an adhesive or other retention mechanism. The silk screen frame may be fabricated of metal, such as aluminum, or any other rigid material.

The silk screen frame 102 is positioned atop and in close proximity to the LCD panel 104. For example, the silk screen frame 102 may be positioned relative to the LCD panel 104 such that a silk screen coated with an ultraviolet sensitive emulsion retained by the silk screen frame 102 is in contact with a surface of a glass substrate of the LCD panel 104. The LCD panel 104 may be a transmissive LCD panel, and in some examples may be a transparent thin-film transistor (TFT) monochrome panel. The size of the LCD panel 104 may be selected to fabricate a silk screen stencil of a desired size. For example, in one implementation the LCD panel 104 may have dimensions of about 203x134x1.16 millimeters (mm), a display area of about 198x124 mm, 5760x3600 resolution, and pixel size of about 33x33 micrometer (µm). In another implementation, the LCD panel 104 may have dimensions of about 302x177x1.16 mm, display area of about 298x167 mm, 6840x3600 resolution, and pixel size of about 46x46 µm. In other implementations, the LCD panel 104 may have different dimensions, display area, resolution, and/or pixel size.

The LCD panel 104 includes a connector 118 for communicatively coupling the LCD panel 104 to a computer. The LCD panel 104 may receive image data from the computer via the connector 118 for producing an image on the LCD panel 104. The image data may configure pixels of the LCD panel 104 to pass light or block light as selected to produce an image.

The LCD panel 104 is positioned between the silk screen frame 102 and the ultraviolet light source 106. The ultraviolet light source 106 emits ultraviolet light in the direction of the LCD panel 104. The ultraviolet light can be passed to the silk screen retained by the silk screen frame 102 according to the state of the pixels of the LCD panel 104 set by the image data received via the connector 118. In some implementations of the ultraviolet light source 106, the ultraviolet light source 106 may emit ultraviolet radiation in a range including a 404 nanometer wavelength spectrum. The intensity of the ultraviolet light may be variable to accommodate various types of ultraviolet sensitive emulsion.

The ultraviolet light source 106 may include multiple light emitting diodes (LEDs) 110 arranged as an array (e.g., a two-dimensional array), where the LEDs 110 emit ultraviolet light directed to the LCD panel 104. The LEDs 110 may be mounted on a substrate 122, such as a printed circuit board. In some examples of the ultraviolet light source 106, the LEDs 110 may be arranged in a two-dimensional array with adjacent LEDs spaced about 27 millimeters apart.

Some examples of the apparatus 100 may include a spherical array lens 112 positioned between the LCD panel 104 and the ultraviolet light source 106. The spherical array lens 112 can shape the ultraviolet light received from the ultraviolet light source 106 to distribute the ultraviolet light evenly across the LCD panel 104. The spherical array lens 112 may include multiple spherical lenses 116 arranged as an array (e.g., a two-dimensional array). The spherical array lens 112 may be fabricated of ultraviolet resistant polycarbonate or glass. Each spherical lens 116 may be aligned with an LED of the ultraviolet light source 106 to focus the ultraviolet light towards the silkscreen.

Some examples of the apparatus 100 may include a cooling system 108 positioned to reduce the temperature of the ultraviolet light source 106. The cooling system 108 may include one or more fans 114 that provide air flow towards the ultraviolet light source 106.

FIG. 1 shows various example dimensions of the apparatus 100. Dimension B represents the thickness of the LCD panel 104 (e.g., about 1.16 mm in some examples). Dimension C represents a spacing between the spherical array lens 112 and the LCD panel 104 (e.g., about 34.29 mm in some examples). Dimension D represents a spacing between the ultraviolet light source 106 and the spherical array lens 112 (e.g., about 12.65 mm in some examples). Dimension E represents a length of the ultraviolet light source 106, the spherical array lens 112, or the LCD panel 104 (e.g., about 203 mm in some examples). These dimensions are provided as examples, and implementations of the apparatus 100 may employ different dimensions.

The ultraviolet light source 106, the cooling system 108, and spherical array lens 112 may be mounted in a housing 120. The LCD panel 104 may be affixed to the housing 120 spaced apart from the ultraviolet light source 106 and/or the spherical array lens 112. The silk screen frame 102 may be coupled to the LCD panel 104 using registration features (e.g., registration blocks) to align the silk screen frame 102 with the LCD panel 104.

FIG. 2 is a side view of the apparatus 100. FIG. 2 shows the silk screen frame 102, the LCD panel 104, the ultraviolet light source 106, and the cooling system 108 positioned as described with reference to FIG. 1. FIG. 2 further illustrates the ultraviolet light source 106 as including a two-dimensional array of the LEDs 110, and the spherical array lens 112 as including a two-dimensional array of the spherical lenses 116. Dimension F represents a width of the ultraviolet light source 106, the spherical array lens 112, or the LCD panel 104 (e.g., about 134 mm in some examples). This dimension is provided as an example, and implementations of the apparatus 100 may employ a different dimension.

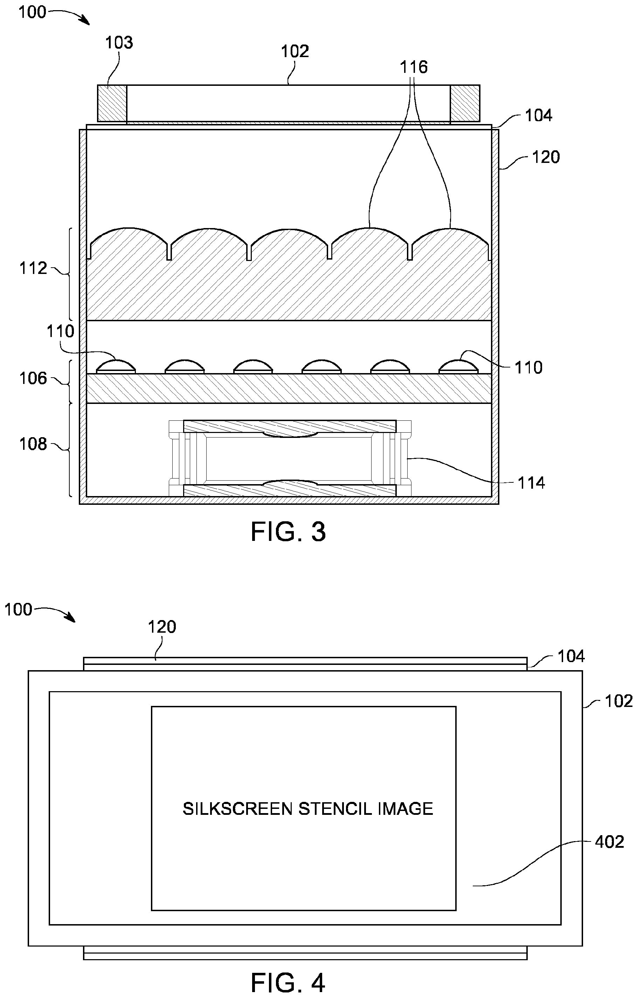

FIG. 3 is a sectional view of the apparatus 100 taken across section line A-A shown in FIG. 1. FIG. 3 shows that the spherical array lens 112, including the spherical lenses 116, may be provided as a single piece assembly. For example, the spherical array lens 112 may be molded of plastic or glass.

FIG. 4 is a top view of the apparatus 100. A silk screen 402 (e.g., coated with an ultraviolet sensitive emulsion) is mounted on the silk screen frame 102 for use in fabrication of a silk screen stencil.

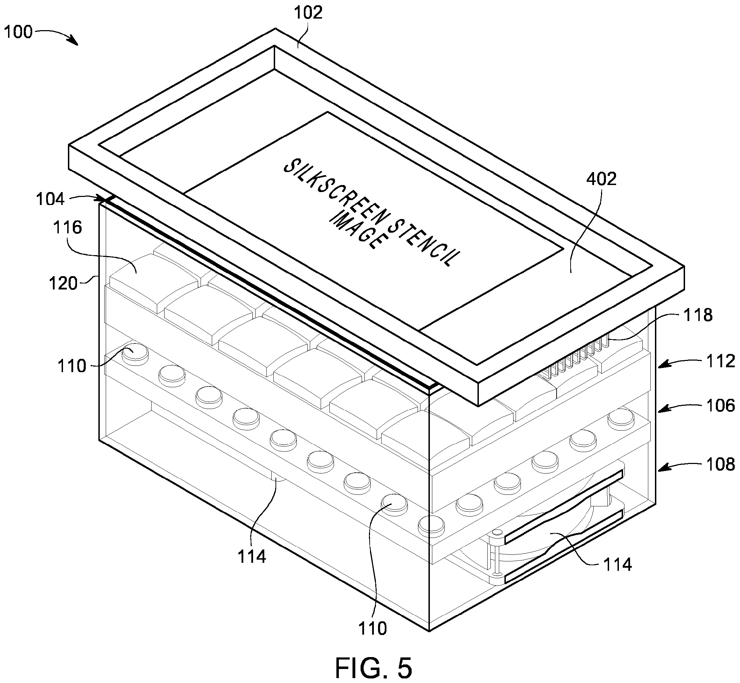

FIG. 5 is an auxiliary view of the apparatus 100. FIG. 5 provides a view of the two-dimensional array of LEDs 110, and the two-dimensional array of the spherical lenses 116.

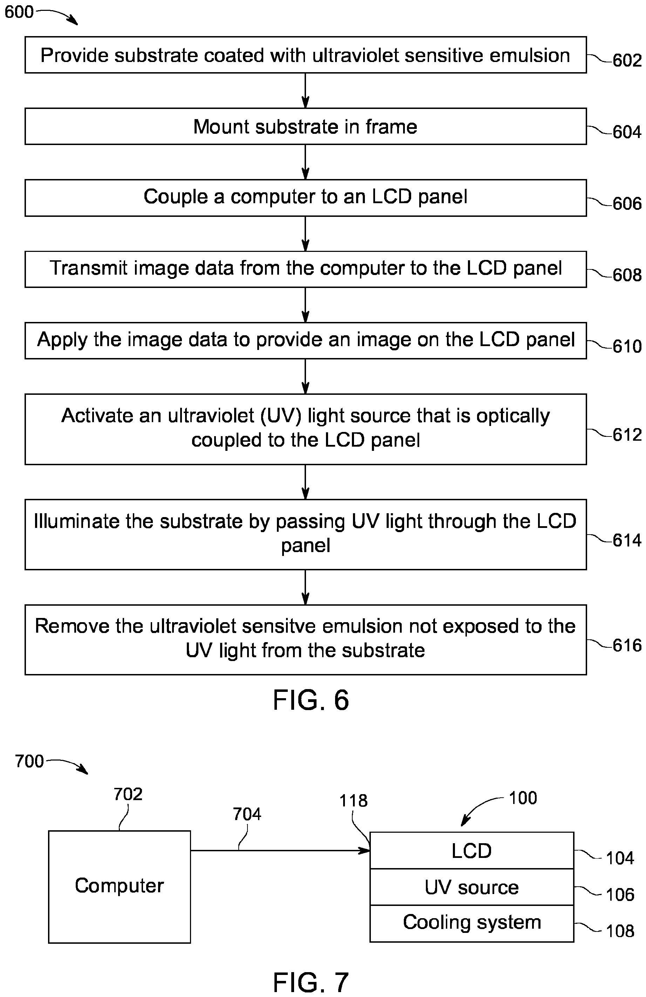

FIG. 6 is a flow diagram of an example method 600 for fabricating a silk screen stencil for use in silk screen printing using the apparatus 100. Though depicted sequentially as a matter of convenience, at least some of the actions shown can be performed in a different order and/or performed in parallel. Additionally, some embodiments may perform only some of the actions shown.

In block 602, a substrate (e.g., silk screen 402) coated with an ultraviolet sensitive emulsion of provided. The silk screen 402 may be made of a nylon or polyester mesh. The substrate may include other materials in some examples.

In block 604, the substrate is mounted in the silk screen frame 102.

In block 606, a computer is communicatively coupled to the LCD panel 104. For example, a cable may be coupled to the connector 118 and to a port (e.g., a video port) of a computer. The port of the computer may be a high-definition multimedia interface (HDMI) port in some examples.

In block 608, the computer transmits image data to the LCD panel 104.

In block 610, the LCD panel 104 applies the image data received from the computer to provide an image on the LCD panel 104. For example, pixels of the LCD panel 104 may be arranged to pass or block light based on the image data received from the computer.

In block 612, the ultraviolet light source 106 is activated to provide ultraviolet light. Activating the ultraviolet light source 106 may include providing current flow through the LEDs 110 (e.g., forward biasing the LEDs 110).

In block 614, the substrate is illuminated by ultraviolet light emitted by the ultraviolet light source 106 that passes through the LCD panel 104. The ultraviolet light passing through the LCD panel 104 forms a pattern on the substrate, which cause the exposed ultraviolet sensitive emulsion to harden or set.

In block 616, ultraviolet sensitive emulsion not exposed to the ultraviolet light may be removed from the substrate. For example, the substrate may be washed with water, or an emulsion remover may be applied to remove the unexposed ultraviolet sensitive emulsion. After removal of the unexposed emulsion, the silk screen stencil produced by the method 600 may be applied in a silk screen printing process.

FIG. 7 is a block diagram of an example system 700 for fabricating a silk screen stencil. The system 700 includes a computer 702 and the apparatus 100. The system 700 may perform at least some of the operations of the method 600. The computer 702 may be a desktop computer, a laptop, computer, a rack-mount computer, or any other computing device capable of providing image data to the apparatus 100. The computer 702 may include a processor, memory, user interface subsystems, and other computing components and subsystems. For example, the computer 702 may include a display system configured to provide image data to the LCD panel 104. The display system may include display software, image creation/storage software, or image communication software executed by a processor of the computer 702, and/or display hardware configured to communicate with the LCD panel 104. The computer 702 may be coupled to the LCD panel 104 via a cable 704. A first connector of the computer 702 may be coupled to the connector 118, and a second connector of the 704 may be coupled to a video port (e.g., and HDMI port) of the computer 702.

In this description, the term "couple" may cover connections, communications, or signal paths that enable a functional relationship consistent with this description. For example, if device A generates a signal to control device B to perform an action: (a) in a first example, device A is coupled to device B by direct connection; or (b) in a second example, device A is coupled to device B through intervening component C if intervening component C does not alter the functional relationship between device A and device B, such that device B is controlled by device A via the control signal generated by device A.

Also, in this description, the recitation "based on" means "based at least in part on." Therefore, if X is based on Y, then X may be a function of Y and any number of other factors.

A device that is "configured to" perform a task or function may be configured (e.g., programmed and/or hardwired) at a time of manufacturing by a manufacturer to perform the function and/or may be configurable (or reconfigurable) by a user after manufacturing to perform the function and/or other additional or alternative functions. The configuring may be through firmware and/or software programming of the device, through a construction and/or layout of hardware components and interconnections of the device, or a combination thereof.

As used herein, the terms "terminal," "node," "interconnection," "pin" and "lead" are used interchangeably. Unless specifically stated to the contrary, these terms are generally used to mean an interconnection between or a terminus of a device element, a circuit element, an integrated circuit, a device or other electronics or semiconductor component.

A device that is described herein as including certain components may instead be adapted to be coupled to those components to form the described device.

Modifications are possible in the described examples, and other examples are possible, within the scope of the claims.

## Claims

1. An apparatus comprising:
a frame configured to retain a substrate;
an ultraviolet light source; and
a liquid crystal display (LCD) panel positioned between the frame and the ultraviolet light source.

2. The apparatus of claim 1, wherein the LCD panel is a transmissive LCD panel.

3. The apparatus of claim 1 or 2, wherein the ultraviolet light source includes a two-dimensional array of ultraviolet light emitting diodes.

4. The apparatus of any of claims 1 to 3, further comprising a spherical array lens positioned between the ultraviolet light source and the LCD panel.

5. The apparatus of any of claims 1 to 4, further comprising a cooling system disposed on a side of the ultraviolet light source opposite the LCD panel, preferably wherein the cooling system includes one or more fans configured to provide air flow to the ultraviolet light source.

6. The apparatus of any of claims 1 to 5, further comprising a computer coupled to the LCD panel, the computer configured to control the LCD panel to pass ultraviolet light from the ultraviolet light source to the frame in a predetermined pattern.

7. A method comprising:
providing a substrate coated with an ultraviolet sensitive emulsion;
providing an image on an LCD panel;
activating an ultraviolet light source to generate ultraviolet light; and
illuminating the substrate by passing the ultraviolet light through the LCD panel to the substrate.

8. The method of claim 7, wherein the LCD panel is a transmissive LCD panel.

9. The method of claim 7 or 8, wherein activating the ultraviolet light source includes forward biasing a plurality of light emitting diodes configured to emit ultraviolet light.

10. The method of any of claims 7 to 9, further comprising passing the ultraviolet light to the LCD panel through a spherical array lens.

11. The method of any of claims 7 to 10, further comprising:
coupling a computer to the LCD panel; and
transmitting image data from the computer to the LCD panel to form the image on the LCD panel.

12. The method of any of claims 7 to 11, further comprising mounting the substrate on a frame coupled to the LCD panel.

13. The method of any of claims 7 to 12, further comprising removing ultraviolet sensitive emulsion not exposed to the ultraviolet light from the substrate to produce a silk screen stencil.

14. A system comprising:
an apparatus according to any of claims 1 to 5; and
a computer coupled to the LCD panel, the computer configured to transfer image data to the LCD panel, the image data defining an image to be transferred to the substrate.

15. The system of claim 14, wherein the image data configures the LCD panel to pass ultraviolet light representative of the image onto a substrate retained in the frame.
